# EUROPEAN PATENT APPLICATION

(11) **EP 2 645 570 A1**
(43) Date of publication of application: **02.10.2013**
(21) Application number: 11843059.4
(22) Date of filing: 25.11.2011
(51) Int. Cl.: H03K 17/945, H03K 17/78

(54) **OPTICAL MOTION SENSOR**

(30) Priority: 26.11.2010 JP 2010263827
(71) Applicant: Rhythm Watch Co., Ltd., Saitama 330-9551 (JP)
(72) Inventor: NASU, Yoshinori, Saitama-shi Saitama 330-9551 (JP)
(74) Representative: Skone James, Robert Edmund
(86) International application number: PCT/JP2011/077870
(87) International publication number: WO 2012/070690

(57) **Abstract**

In order to provide an optical motion sensor which can detect the movement of a person easily and in an ensured fashion with a relatively simple circuit configuration in an environment where the brightness changes completely, a circuit configuration is provided in which a photodetector 15 and a voltage uniforming circuit 21 are connected in series, a connecting point between the photodetector 15 and the voltage uniforming circuit 21 is connected to a signal output terminal 39 via a differential amplifier circuit 31 and a pulse forming circuit 37, and the voltage uniforming circuit comprises a transistor whose emitter is grounded, a condenser which is inserted between a base and the emitter of the transistor and a resistance which is inserted between the base and a collector of the transistor, the collector of the transistor being connected to the photodetector.

## Description

### Technical Field

The present invention relates to an optical motion sensor for detecting the existence of a motion in front of the sensor by means of a photodetector.

### Background Art

Currently, it is widely exercised to detect the movement of a person or an object by using a photodetector such as a photodiode or a phototransistor. For example, KOKAI (Japanese Unexamined Patent Application) No. 10-27451 (Patent Literature 1) proposes a stationary detector unit which can detect not only the movement of an object but also the moving direction thereof in a wide range.

Additionally, there are photocommunication receivers using a photodetector such as a photodiode. For example, KOKAI (Japanese Unexamined Patent Application) No. 11-186971 (Patent Literature 2) proposes an optical receiver in which a plurality of amplifier devices having different amplitude factors are provided in the optical receiver, and the intensity of light received by a photodetector is detected by an intensity monitoring device, whereby the amplifier devices are switched according to the intensity of light received by the photodetector so as not to reduce the light sensitivity while maintaining the dynamic range.

In addition, since photodetectors such as photodiodes are small in size, light in weight and inexpensive in price, photodetectors are incorporated in domestic interior ornament for use as sensors for detecting the movement of a person within a room so that those domestic interior ornaments are activated when the movement of a person is detected thereby.

### Related Art Literatures

### Patent Literatures

Patent Literature 1: KOKAI (Japanese Unexamined Patent Application) No. Hei10-274517
Patent Literature 2: KOKAI (Japanese Unexamined Patent Application) No. Hei11-186971

### Summary of the Invention

### Problem that the Invention is to Solve

When an interior ornament is placed in a room, depending upon where the interior ornament is placed in the room, the illuminance of the environment where the appliance is placed tends to range from several tens to hundreds of lux. Additionally, the illuminance of a place by a window in the daytime reaches 2000 lux or more from time to time.

Because of this, in the event that the detection sensitivity of a photodetector is set based on the brightness of a room where no sunlight enters in the daytime, the detection value of a sensor reaches a saturation state when sunlight enters a room where the sensor is placed, it becomes impossible to detect the movement of a person, for example. On the other hand, in the event that the detection sensitivity of the photodetector is set so as to be applicable to a bright room by taking sunlight into consideration, the detection sensitivity of the sensor is reduced in the room at night, and there have been situations in which the proper operation of the sensor is not ensured.

In addition, a plurality of amplifier circuits having different amplitude factors are incorporated in a sensor by taking into consideration a difference in illuminance between day and night so that the amplifier circuits can be switched depending upon the illuminance detected to ensure the detection sensitivity of the sensor, there is provided a drawback that the circuit configuration of the sensor becomes complex as a motion sensor that is incorporated in a simple interior appliance to detect the movement of a person.

The invention has been made to eliminate the drawbacks inherent in the related art and an object thereof is to provide a small optical motion sensor with relatively simple circuit configuration that is suitable for incorporation in an interior appliance and which can detect the movement of a person easily and in an ensured fashion throughout the day and night within a room where the illuminance differs totally between day and night.

### Means for Solving the Problem

According to an aspect of the invention, there is provided an optical motion sensor having a circuit configuration in which a photodetector and a voltage uniforming circuit are connected in series and a connecting point between the photodetector and the voltage uniforming circuit is connected to a signal output terminal via a differential amplifier circuit and a pulse forming circuit.

Additionally, the voltage uniforming circuit includes a transistor whose emitter is grounded, a condenser which is inserted between a base and the emitter of the transistor and a resistance which is inserted between the base and a collector of the transistor, and the collector of the transistor is connected to the photodetector.

In addition, the differential amplifier circuit includes a coupling condenser and an inverting amplifier and is configured so that a change in collector potential of the voltage uniforming circuit is inputted into the inverting amplifier via the coupling condenser, whereby the inverting amplifier amplifies the collector potential by an amount corresponding to the change in collector potential for output.

Further, the pulse forming circuit is desirably a binarizing circuit.

Additionally, in an interior of a cylindrical body having an opening portion at one end thereof, the photodetector is desirably fixed to near the other end of the cylindrical body which is a different end from the end where the opening portion is provided.

### Advantage of the Invention

In the optical motion sensor according to the invention, the photodetector and the voltage uniforming circuit are connected in series, and even though the amount of light entering the photodetector changes moderately and largely, the emitter potential of the photodetector changes small, whereby the proper operation of the photodetector can be maintained whether the optical motion sensor is placed in a bright place or a dimly lit place.

In addition, the voltage uniforming circuit is connected so that the condenser is inserted between the base and the emitter of the transistor whose emitter is grounded, and the resistance is inserted between the base and the collector of the transistor. Thus, even in the event that the value of a current supplied to the collector of the transistor changes largely, when the value of the current changes moderately, the variation of the collector potential is maintained small, whereas when the value of the current supplied to the collector changes drastically, the collector potential can be caused to change clearly.

Additionally, although it has the simple circuit configuration, the differential amplifier circuit can easily amplify a change in input potential, and a stable output signal can be formed by the pulse forming circuit having the simple circuit configuration.

Further, in the event that the photodetector is fixed to near the one end of the interior of the cylindrical body to restrict its field of view, it is possible to detect an object moving across the field of view in a more ensured fashion.

### Brief Description of the Drawings

Fig. 1 is a diagram showing a circuit configuration of an optical motion sensor according to the invention.
Fig. 2 is a diagram showing the construction of a light sensing portion of the optical motion sensor according to the invention.
Fig. 3 is a diagram showing an example of an interior ornament into which the optical motion sensor is incorporated.
Fig. 4 shows graphs at (1) and (2) which show a change in brightness within a room and a change in voltage of the optical motion sensor according to the invention, respectively.
Fig. 5 shows diagrams at (1), (2) and (3) which show voltage signals when the optical motion sensor according to the invention detects motions, respectively.

### Description of Reference Numerals

10 light sensing portion; 11 cylindrical body; 13 fixing member; 15 photodetector; 17 opening portion; 21 voltage uniforming circuit; 23 voltage regulating transistor; 25 bias condenser; 27 regulating resistance; 31 differential amplifier circuit; 33 coupling condenser; 35 inverting amplifier; 37 pulse forming circuit; 39 signal output terminal; 40 clock unit; 41 hour/minute display portion; 43 setting switch; 45 movable decorative unit.

### Mode for Carrying out the Invention

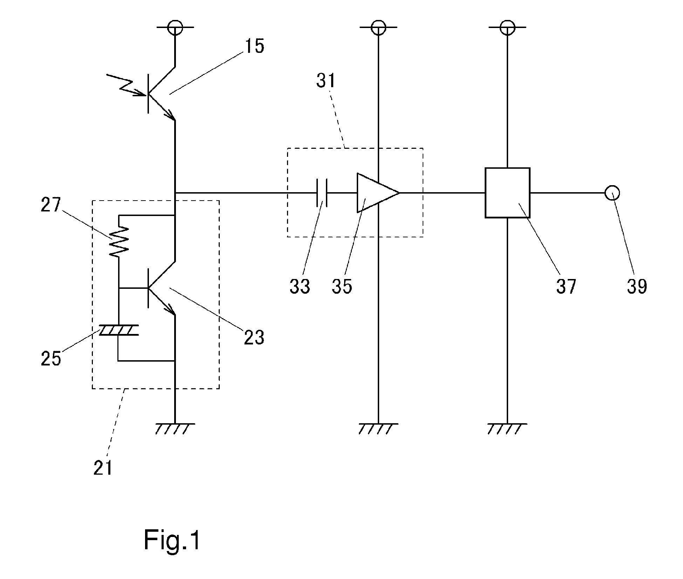

As shown in Fig. 1, an optical motion sensor according to the invention uses a phototransistor which is a current-type output photodetector as a photodetector 15. The photodetector 15 and a voltage uniforming circuit 21 are disposed in series between power supply terminals so that the phototransistor is inserted between the voltage uniforming circuit 21 and a positive power supply. A connecting point between the photodetector 15 and the voltage uniforming circuit 21 is connected to an input terminal of a differential amplifier circuit 31. Then, an output terminal of the differential amplifier circuit 31 is connected to a signal output terminal 39 via a pulse forming circuit 37.

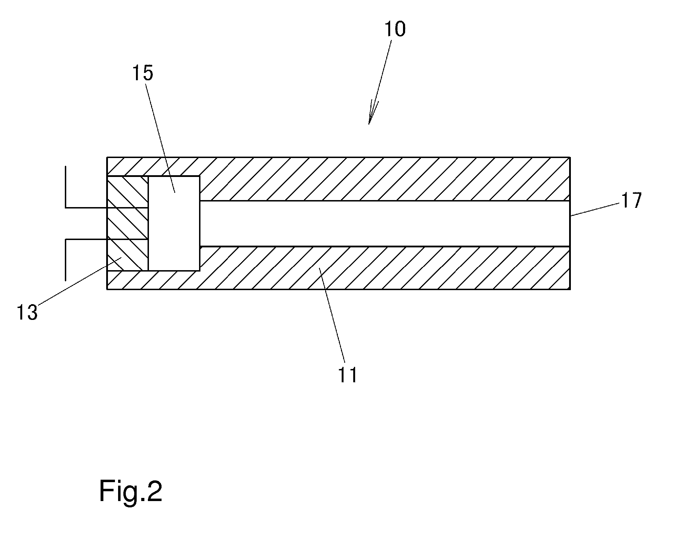

Additionally, in a light sensing portion 10 where the photodetector 15 is provided, as shown in Fig. 2, the photodetector 15 is disposed in a deep portion of a cylindrical body 11, and the photodetector 15 is fixed to near one end of the cylindrical body 11 by a fixing member 13. A distance from the photodetector 15 to an opening portion 17 of the cylindrical body 11 is made several times larger than a bore diameter of the cylindrical body 11.

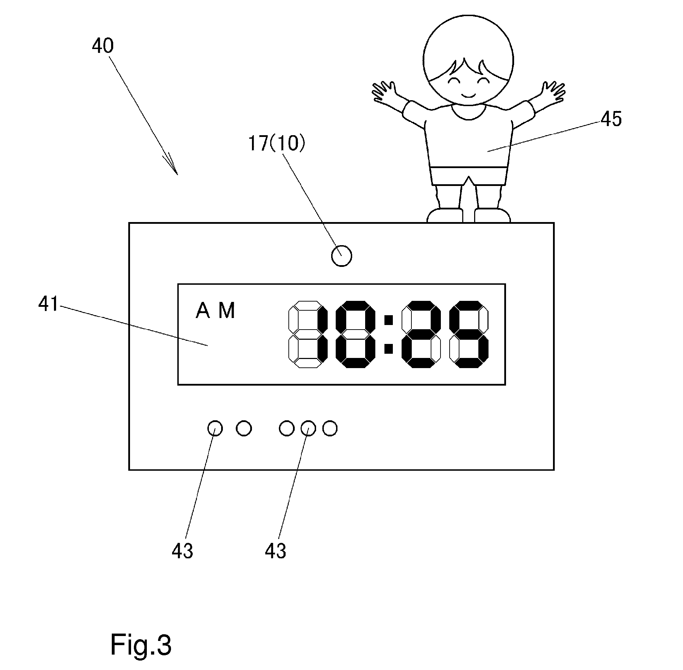

Additionally, this optical motion sensor is incorporated, for example, in a clock unit 40 shown in Fig. 3. The clock unit 40 is made into a digital clock and has a plurality of setting switches 43 such as an hour/minute setting switch and an alarm setting switch, accommodating therein the light sensing portion 10 of the optical motion sensor above an hour/minute display portion 41 with the opening portion 17 of the cylindrical body 11 disposed to be exposed to the outside of the clock unit 40. In addition, the clock unit 40 has a figure which is a movable decorative unit 45.

In addition, the movable decorative unit 45 is configured so as to do such an action as moving a hand or produce a voice or a sound from a speaker when the movement or the like of a person is detected in front of the clock unit 40 by the optical motion sensor.

Further, in the voltage uniforming circuit 21 of the optical motion sensor, as shown in Fig. 1, a condenser, which is a bias condenser 25, is inserted between an emitter and a base of a voltage regulating transistor 23 which is a transistor whose emitter is grounded, and a resistance, which is a regulating resistance 27, is inserted between a collector and the base of the voltage regulating transistor 23. The collector of the voltage regulating transistor 23 is connected to an emitter of the phototransistor and is connected to the differential amplifier circuit 31.

This differential amplifier circuit 31 includes a coupling condenser 33 and an inverting amplifier 35 and inputs an output of the voltage uniforming circuit 21 into the inverting amplifier 35 via the coupling condenser 33.

In addition, the pulse forming circuit 37 uses a binarizing circuit and outputs an on signal of a definite value when an input voltage exceeds a threshold of 1.5V, for example, and outputs an off signal of about 0V when the input voltage is equal to or lower than the threshold.

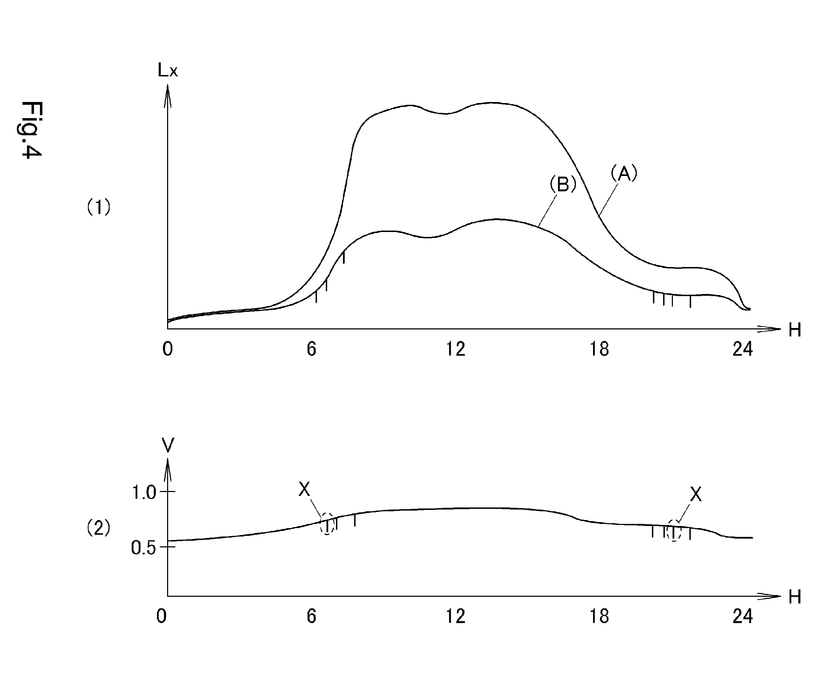

Then, in the event that the photodetector 15 is disposed deep into the cylindrical body 11, as shown at (1) in Fig. 4, when the brightness in a room changes from several lux to on the order of 2000 lx as indicated by a curve denoted as (A), the illuminance sensed by the phototransistor which is the photodetector 15 disposed deep into the cylindrical body 11 changes from several lux to on the order of hundreds of lux as indicated by a curve denoted as (B).

Further, when the luminance of light incident onto the photodetector 15 changes several lux to on the order of hundreds of lux in the way described above, assuming that the capacity of the bias condenser 25 of the voltage uniforming circuit 21 is on the order of 10 µF, the resistance value of the regulating resistance 27 is in the range of hundreds of kilo-ohms to on the order of 1 MΩ, and the power supply voltage is 3 V, it is possible to restrain a collector potential of the voltage regulating transistor 23 which is an output voltage of the voltage uniforming circuit 21 from changing from slightly larger than 0.5 V to slightly smaller than 0.7 V, as shown at (2) in Fig. 4.

Namely, in the voltage uniforming circuit 21, an output current of the photodetector 15 is caused to flow to a negative power supply while dividing it into a resistance current which flows through the regulating resistance 27 and a collector current of the voltage regulating transistor 23, so that the collector potential of the voltage regulating transistor 23 is stabilized to a voltage having a slightly higher value than a potential between the base and the emitter of the voltage regulating transistor 23 which is about 0.5 V. Thus, even though the luminance of light incident on the photodetector 15 changes moderately, the collector potential can be stabilized by keeping small the change in collector potential of the voltage regulating transistor 23.

In this way, even though the luminance of light incident on the photodetector 15 changes moderately and largely, by keeping the output of the voltage uniforming circuit 21 substantially constant, a change in emitter potential of the photodetector 15 is kept small whereby the photodetector 15 is allowed to be kept operating in a stable fashion.

Consequently, when a person moves across the front of the clock unit 40 or moves his or her hand near the opening portion 17 provided in the clock unit 40, causing the movement of the person to occur within the field of view of the photodetector 15 via the cylindrical body 11, the amount of light incident on the photodetector 15 is reduced, and a decreasing change in emitter current of the photodetector 15 can be caused to occur in an ensured fashion.

In this way, when the emitter current of the photodetector 15 is reduced, the current flowing to the regulating resistance 27 is reduced, whereby the voltage regulating transistor 23 is kept energized as a result of the voltage being held by the bias condenser 25. Thus, a voltage drop of zero point several volt is produced in the output of the voltage uniforming circuit 21 as indicated by a curve denoted as X at (2) in Fig. 4.

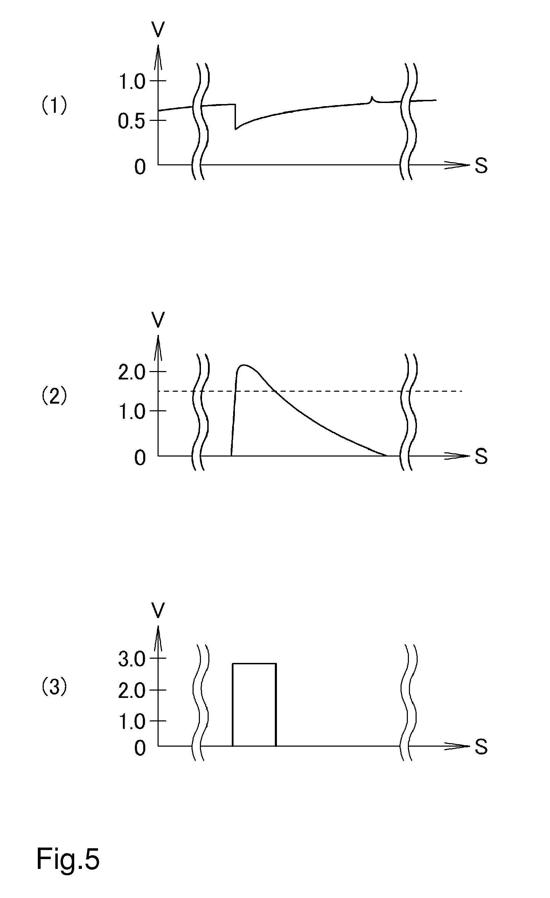

As shown at (1) in Fig. 5, this voltage drop corresponds to a voltage drop of zero point several second to on the order of 1 second with the movement of a normal person. A voltage corresponding to this voltage fluctuation is inputted into the inverting amplifier 35 via the coupling condenser 33 of the differential amplifier circuit 31, whereby the fluctuating voltage can be amplified to on the order of 2 V as shown at (2) in Fig. 5.

In addition, by using the binarizing circuit having the threshold of the order of 1.5 V as the pulse forming circuit 37, as shown at (3) in Fig. 5, a pulse signal having a voltage whose peak value is about 3 V can be formed for output to a signal output terminal 39.

It should be noted that the threshold of the binarizing circuit is not limited to 1.5 V and hence can be set to 1 V or as required according to the output of the differential amplifier circuit 31 which depends on the photoelectric conversion efficiency of the photodetector 15 or the amplitude factor of the inverting amplifier 35. In place of the binarizing circuit, a pulse generating circuit such as a single-shot multivibrator can also be used as the pulse forming circuit 37. Nonetheless, in the event that the binarizing circuit is used as the pulse forming circuit 37, the pulse forming circuit 37 can easily be formed small in size by using a single transistor and several resistances.

Additionally, the inverting amplifier 35 of the differential amplifier circuit 31 can also be formed easily by using a single transistor and several resistances or condensers, whereby the small and simple circuit configuration of the differential amplifier circuit 31 can easily be realized.

In addition, in this optical motion sensor, the photodetector 15 is disposed in the deep position in the cylindrical body 11 which is situated at the other end thereof which is different from the one end where the opening portion 17 is formed, whereby the range of the field of view of the photodetector 15 is restricted. Because of this, for example, when a person moves across the front of the clock unit 40, in many cases, the whole of the field of view of the photodetector 15 is interrupted completely by part of the body of the person, whereby a change within the field of view is made large to increase the change factor of the amount of light sensed by the photodetector 15, thereby making it possible to detect the movement of a person in a more ensured fashion.

Consequently, the optical motion sensor is made up of the voltage uniforming circuit 21, the differential amplifier circuit 31 and the pulse forming circuit 37, which are each formed simple in circuit configuration by using the transistor, and therefore, the optical motion sensor can surely detect the movement of a person with the small and simple circuit even in an environment where the brightness changes largely.

Then, when a person moves in front of the clock unit 40 which is an interior ornament, a control circuit of the movable decorative unit 45 is activated by a pulse signal which is an output signal of the optical motion sensor so as to actuate the movable decorative unit 45 which is a movable portion of the clock unit 40.

### Industrial Applicability

Since the optical motion sensor according to the invention can detect the movement of a person to thereby form an output signal in an ensured fashion with the small and simple circuit configuration even in the environment where the brightness changes largely, the optical motion sensor can easily be incorporated in an interior ornament which responds to the movement of a person so as to activate the interior ornament.

## Claims

1. An optical motion sensor **characterized by** having a circuit configuration in which a photodetector and a voltage uniforming circuit are connected in series and a connecting point between the photodetector and the voltage uniforming circuit is connected to a signal output terminal via a differential amplifier circuit and a pulse forming circuit, and **characterized in that** the voltage uniforming circuit comprises a transistor whose emitter is grounded, a condenser which is inserted between a base and the emitter of the transistor and a resistance which is inserted between the base and a collector of the transistor, the collector of the transistor being connected to the photodetector.

2. The optical motion sensor according to Claim 1, **characterized in that** the differential amplifier circuit comprises a coupling condenser and an inverting amplifier, and **in that** a change in collector potential of the voltage uniforming circuit is inputted into the inverting amplifier via the coupling condenser, and the inverting amplifier amplifies the collector potential by an amount corresponding the change in collector potential for output.

3. The optical motion sensor according to Claim 2, **characterized in that** the pulse forming circuit is a binarizing circuit.

4. The optical motion sensor according to Claim 1 or 2, **characterized in that** in an interior of a cylindrical body having an opening portion at one end thereof, the photodetector is fixed to near the other end of the cylindrical body.

5. The optical motion sensor according to Claim 3, **characterized in that** in an interior of a cylindrical body having an opening portion at one end thereof, the photodetector is fixed to near the other end of the cylindrical body.
